# EUROPÄISCHE PATENTSCHRIFT

(11) **EP 3 640 767 B1**
(45) Veröffentlichungstag und Bekanntmachung des Hinweises auf die Patenterteilung: **11.09.2024**
(21) Anmeldenummer: 18200985.2
(22) Anmeldetag: 17.10.2018
(51) Int. Cl.: G06F 3/01, G06T 19/00, G06T 19/20, G06F 30/00, G06F 30/13

(54) **VERFAHREN ZUM BESTIMMEN MINDESTENS EINES BEREICHS IN MINDESTENS EINEM EINGABEMODELL FÜR MINDESTENS EIN ZU PLATZIERENDES ELEMENT**
METHOD FOR DETERMINING AT LEAST ONE AREA IN AT LEAST ONE INPUT MODEL FOR AT LEAST ONE ELEMENT TO BE PLACED
PROCÉDÉ DE DÉTERMINATION D'AU MOINS UNE ZONE DANS AU MOINS UN MODÈLE D'ENTRÉE POUR AU MOINS UN ÉLÉMENT À PLACER

(43) Veröffentlichungstag der Anmeldung: 22.04.2020
(73) Patentinhaber: Siemens Schweiz AG, 8047 Zürich (CH)
(72) Erfinder: Frey, Christian, 6314 Unterägeri (CH); Klein, Wolfram, 85579 Neubiberg (DE); Mayer, Hermann Georg, 83209 Prien am Chiemsee (DE)
(74) Vertreter: Siemens Patent Attorneys

(56) Entgegenhaltungen:
- WO-A1-2020/055649
- US-A- 5 444 836
- US-A1- 2010 306 681
- US-A1- 2016 171 143
- US-A1- 2018 096 528
- SIRAJ D SHAN: "JudgeMaster: Automated chess movement validator", 2017 NATIONAL INFORMATION TECHNOLOGY CONFERENCE (NITC), IEEE, 14 September 2017 (2017-09-14), pages 112 - 118, XP033316160, DOI: 10.1109/NITC.2017.8285662

## Beschreibung

### 1. Technisches Gebiet

Die Erfindung betrifft ein computer-implementiertes Verfahren zum Bestimmen mindestens eines Bereichs in mindestens einem Eingabemodell für mindestens ein zu platzierendes Element. Ferner ist die Erfindung auf eine entsprechende Recheneinheit und Computerprogrammprodukt gerichtet. Die Erfindung kann insbesondere in dem technischen Bereich der Gebäudeausrüstung angesiedelt sein.

### 2. Stand der Technik

Virtual Reality, oder auch Virtuelle Realität (VR) genannt, gewinnt zunehmend an Bedeutung. Die virtuelle Realität bezeichnet die Darstellung einer virtuellen Welt, welche computergeneriert ist. Die virtuelle Welt kann beispielsweise an die reale Welt angelehnt sein. Ferner steht die virtuelle Realität in engem Zusammenhang mit VR-Brillen. Durch den Einsatz der VR-Brillen ist der Anwender vorteilhafterweise nicht mehr auf den Monitor angewiesen, sondern hat ein 3D-Bild zur Verfügung und kann den Kopf komfortabel in alle Richtungen drehen, um die virtuelle Welt zu verfolgen.

Durch die VR-Brille kann der Anwender auch einen Gebäudeplan dreidimensional wahrnehmen. In diesen Gebäudeplan müssen oftmals nachträglich Brandmeldevorrichtungen oder andere zu platzierende Elemente platziert werden. Demnach ist oftmals eine Änderung des Gebäudeplans, wie Erweiterung um ein Element, erforderlich.

Gemäß dem Stand der Technik wird die Installation oder Platzierung eines zu platzierenden Elementes in den Gebäudeplan, wie beispielsweise Brandmelder bzw. Brandmeldevorrichtung, durch einen Fachexperten manuell vorgenommen. Der Fachexperte muss hierbei jedoch auf komplexe und zeitaufwendige Art und Weise sicherstellen, dass bestimmte Regeln, Normen und/oder auch Randbedingungen erfüllt werden. Beispielsweise muss der Brandmelder einen bestimmten Abstand von einer Wand wahren etc., siehe weiter unten. Herkömmlicherweise platziert der Fachexperte in mehreren Durchläufen manuell das zu platzierende Element. Die Regeln, Normen oder Randbedingungen müssen überprüft und erfüllt werden. Anschließend wird der Gebäudeplan von einer zertifizierenden Stelle geprüft und abgenommen.

Dokument US 2018/0096528 A1 betrifft die automatische Platzierung eines Augmented Reality ("AR") - Modells. Das AR System weist einen Scanner zum Scannen eines Raums auf, um ein 3D Model des Raums, Personen und Objekte innerhalb des Raums bereitzustellen. Ferner weist das AR System einen Stellen-Identifizierer ("location identifier") auf, welcher an einen Modellspeicher gekoppelt ist, um eine oder mehrere Kandidatenstellen in dem Raum für das AR Modell zu erkennen. Der Stellen-Identifizierer berücksichtigt bei der Identifizierung Platzierungsbedingungen. Ferner weist das AR System auch einen Stellen-Indikator auf, um eine Platzierungsstelle in dem Raum für das AR Model auszuwählen.

Dokument US 5,444,836 offenbart eine Vorrichtung und Verfahren zum Erzeugen sowie Anwenden flexibler, benutzerdefinierter Regeln zur Platzierung graphischer Objekte in einer Computer Aided Drafting ("CAD") Anwendung.

Dokument US 2016/0171143 A1 betrifft ein Circuit design layout in vielfachen synchronen Darstellungen.

Die vorliegende Erfindung stellt sich daher die objektive technische Aufgabe ein Verfahren zum Bestimmen mindestens eines Bereichs in mindestens einem Eingabemodells für mindestens ein zu platzierendes Element bereitzustellen, welches zuverlässiger und effizienter ist.

Das Dokument US 2010/0306681 A1 offenbart ein Softwaresystem zur Platzierung von funktionalen Komponenten gemäß Figur 2A. Das Softwaresystem kann basierend auf den Attributen und den Parametern der Objekte innerhalb des Entwurfraums ("design space") sicherstellen, dass keine funktionale Komponente an einem ungültigen Ort platziert wird. Das Softwaresystem kann erkennen, dass der Benutzer einen Behälter ("receptacle") nahe einer Senke platzierte. Das Softwaresystem kann basierend auf den Parametern des Behälters ebenfalls erkennen, dass nur GFCI-Behälter in der Nähe einer Senke platziert werden können. Damit kann das Softwaresystem identifizieren, dass die Position des Behälters ungültig ist. Das Softwaresystem kann damit auch sicherstellen, dass der Behälter an einer "gültigen" Position positioniert ist.

Das Dokument SIRAJ D SHAN: "JudgeMaster: Automated chess movement validator", 2017 NATIONAL INFORMATION TECHNOLOGY CONFERENCE (NITC), IEEE, 14. September 2017 (2017-09-14), Seiten 112-118, XP033316160, DOI: 10.1109/NITC.2017.8285662 [gefunden am 2018-02-07] offenbart ein Schachfigur-Anordnungs-Detektions- und Bewegungs-Validierungs- System ("a chess piece arrangement detection and movement validation system"), welches die Bewegungen aufzeichnet und das Spiel gemäß den Schachregeln beurteilt. Das System kann als automatisches Urteil in einem realen Spiel verwendet werden. Die Figur-Anordnungen werden dabei durch die Verarbeitung von Bildern identifiziert.

Das Dokument WO 2020/055649 A1 offenbart ein Verfahren zum Entwerfen eines Feuermeldesystems.

### 3. Zusammenfassung der Erfindung

Die oben genannte Aufgabe wird durch den Gegenstand der beigefügten Ansprüche gelöst.

### 4. Detaillierte Beschreibung

Selbst wenn nicht alle beanspruchten Schritte enthalten sind, wird zum Verständnis der Erfindung ein Verfahren mit folgenden Schritten beschrieben:
a. Empfangen eines Eingabedatensatzes aufweisend das mindestens eine zu platzierende Element, eine Vielzahl von Bedingungen; das mindestens eine Eingabemodell;
b. Bestimmen mindestens einer zugehörigen Bedingung aus der Vielzahl von Bedingungen; und
c. Bestimmen mindestens eines gültigen und/oder ungültigen Bereichs des mindestens einen Eingabemodells in Abhängigkeit von der zugehörigen Bedingung; wobei
d. der mindestens eine gültige Bereich die zugehörige Bedingung zumindest zum Teil erfüllt.

Dementsprechend ist die Erfindung auf ein Verfahren zum Bestimmen mindestens eines Bereichs eines Eingabemodells für ein zu platzierendes Element gerichtet.

In einem ersten Schritt wird ein Eingabedatensatz empfangen. Der Eingabedatensatz umfasst zumindest das zu platzierende Element, die Vielzahl der Bedingungen und ein Eingabemodell.

Das zu platzierende Element ist dasjenige Element, welches mit Hilfe des Verfahrens platziert wird. Beispielhafte Elemente sind Elemente eines Bauwerks, insbesondere eines Gebäudes, wie Brandmelder und Rauchmelder. Weitere andere beispielhafte Elemente sind Sensoren und Aktuatoren. Hierbei kann es sich um ein neues Element oder um ein bereits bestehendes Element handeln. Beispielsweise kann ein neues Element oder sonstiges Element erstmalig platziert werden oder erneut platziert werden.

Die Bedingungen können auch als Vorgaben bezeichnet werden. Sie müssen bei der Platzierung des zu platzierenden Elementes in einem Bereich des Eingabemodells berücksichtigt werden. Das zu platzierende Element darf lediglich in bestimmte Bereiche des Eingabemodells platziert werden, welche die Bedingungen erfüllen. Mit anderen Worten kann das platzierende Element nicht an beliebiger Stelle platziert werden. Der Begriff Platzieren kann auch als Einrichten oder Installieren ausgelegt werden. Beispielhafte Bedingungen sind Regeln und Normen, wie Abstandsregeln für Rauchmelder oder Brandmelder, Erreichbarkeitskriterien der Handmelder, Sichtbarkeitskriterien für optische Warneinrichtungen etc. Hinsichtlich der Abstandsregeln müssen beispielsweise die Brandmelder einen bestimmten Abstand von der Wand oder auch Steckdosen einen bestimmten Abstand vom Fußboden haben. Dieser Abstand kann auch als Mindestabstand betrachtet werden. Ferner müssen die Erfassungsbereiche aller Brandmelder in einem Raum die Grundfläche des Raums abdecken usw.

Das Eingabemodell kann zweidimensional oder dreidimensional ausgestaltet sein. Beispielsweise ist das dreidimensionale digitale Modell ein computergeneriertes CAD- oder ifc-Modell, in welchem das Bauwerk als virtuelles Modell geometrisch visualisiert ist. Vorzugsweise sind in dem obigen Gebäudemodell die Gebäudeteile semantisch annotiert. Das Eingabemodell kann einem Benutzer dargestellt werden, insbesondere durch eine Virtual Reality (VR)- oder Augmented Reality (AR)- Brille. Alternativ können andere Anzeigeeinheiten verwendet werden.

Bei AR ist eine Überlagerung zum realen Gebäude visualisiert, während bei VR nur die virtuelle Welt dargestellt wird. VR hat sich hinsichtlich der Planung eines Neubaus als vorteilhaft erwiesen, da noch kein reales Gebäude vorhanden ist. AR kann dagegen bei existierenden Gebäuden vorteilhafterweise zum Einsatz kommen, wobei die virtuelle Welt der realen Welt visuell überlagert wird.

In einem zweiten Schritt werden diejenigen ein oder mehreren Bedingungen ausgewählt, welche mit dem zu platzierenden Element in Verbindung stehen oder mit diesem assoziiert werden können. Beispielsweise können sich die Bedingungen hinsichtlich des Platzierungsbereichs unterscheiden, wie nach Region, Land, Bundesland, Kanton etc. Ferner können sich die Bedingungen hinsichtlich des Gebäudetyps unterscheiden, wie Bürogebäude, Krankenhaus, Flughafen, Wohnhaus, Lagerhaus etc. Ferner können sich die Bedingungen hinsichtlich Raum- oder Zimmertyp unterscheiden, wie Bürozimmer, Küche, Waschraum, Lagerraum etc. Die zutreffenden Regeln werden für das zu platzierende Element ausgewählt und in dem nächsten Schritt berücksichtigt.

In einem dritten Schritt wird der mindestens eine gültige und/oder ungültige Bereich des Eingabemodells in Abhängigkeit von der mindestens einen zugehörigen Bedingung bestimmt. Mit anderen Worten wird die zugehörige Bedingung auf das Eingabemodell angewendet. Die gültigen und ungültigen Bereiche können anhand der zugehörigen Bedingung festgestellt werden. Die Bereiche sind insbesondere Teilbereiche des Eingabemodells bzw. der zugrundeliegenden Einheit. Die zugrundeliegende Einheit kann das obige Gebäude sein. Die gültigen Bereiche können auch als zulässige Bereiche bezeichnet werden, in welche das zu platzierende Element platziert werden soll. Bezugnehmend auf das obige Beispiel eines Brandmelders, bestimmt das erfindungsgemäße Verfahren denjenigen Teilbereich des Gebäudes, in welchem der Brandmelder die Bedingung des Mindestabstands von den Wänden und/oder weitere Bedingungen erfüllt.

Der Vorteil liegt darin, dass das erfindungsgemäße Verfahren zum Bestimmen mindestens eines Bereichs eines Eingabemodells für ein zu platzierendes Element sowie weitere Schritte der Platzierung selbständig oder eigenständig durch eine Recheneinheit effizient durchgeführt wird. Dadurch kann Fachpersonal mit Expertenknowhow sowie Zeit eingespart werden. Weiterhin ist die Recheneinheit vorteilhafterweise weniger fehleranfällig und somit zuverlässiger. Folglich können die Kosten, die beispielsweise durch mögliche spätere Korrekturen verursacht werden, vermieden oder zumindest erheblich reduziert werden.

Durch das Verfahren können somit bestehende Gebäudepläne flexibel und dynamisch angepasst werden ohne Expertenwissen oder andere Komponenten zu benötigen. Der Gebäudeplan kann somit jederzeit beliebig auch von Nichtexperten um Elemente erweitert werden, da direktes visuelles Feedback über die Regelkonformität gegeben wird. Dadurch wird die Anpassbarkeit und Reaktionszeit auf Änderungen erheblich verbessert.

In einer Ausgestaltung weist das Verfahren weiterhin das Anzeigen des mindestens einen gültigen Bereichs und/oder des mindestens einen ungültigen Bereichs auf, insbesondere durch eine Virtual Reality (VR)- oder Augmented Reality (AR)- Brille oder eine sonstige Anzeigeeinheit. Dementsprechend kann dem Benutzer das Eingabemodell dargestellt werden, insbesondere durch eine Virtual Reality (VR)- oder Augmented Reality (AR)- Brille, wie weiter oben geschrieben. Zusätzlich können dem Benutzer auch weitere Daten angezeigt werden. Zusätzlich kann der bestimmte Bereich dem Benutzer farblich angezeigt werden.

In einer weiteren Ausgestaltung weist das Verfahren weiterhin das Platzieren des mindestens einen zu platzierenden Elementes in den mindestens einen bestimmten Bereich des Eingabemodells auf; wobei das Platzieren das
- Durchführen mindestens einer Platzierungsmaßnahme, falls der mindestens eine Bereich ein gültiger Bereich ist; oder
- Ausgeben eines Platzierungsfehlers, falls der mindestens eine Bereich ein ungültiger Bereich ist;
umfasst.

Dementsprechend kann im Fall einer VR-Brille der Benutzer den Ort oder die Stelle der Platzierung in dem gültigen Bereich durch seine Blickrichtung bestimmen und eine Aktion oder Maßnahme durchführen. Im anderen Fall einer AR-Brille kann der tatsächliche gültige Bereich und/oder der Ort auch durch eine Positionsbestimmungseinheit referenziert werden.

In einer weiteren Ausgestaltung weist das Verfahren weiterhin das Anzeigen des platzierten Elementes in dem mindestens einen gültigen Bereich nach dem Durchführen der mindestens einen Platzierungsmaßnahme und/oder des Platzierungsfehlers nach Erkennung des Platzierungsfehlers auf. Dementsprechend kann der bestimmte gültige Bereich mit oder ohne dem platzierten Element dem Benutzer ebenfalls visuell angezeigt werden. Vor der Platzierung zeigt die Anzeige folglich noch kein platziertes Element an, sondern erst nach erfolgreicher Platzierung. Andernfalls, nach erfolgloser Platzierung im Fehlerfall, kann der Platzierungsfehler angezeigt oder anderweitig ausgegeben werden.

In einer weiteren Ausgestaltung ist die mindestens eine Platzierungsmaßnahme ein Nutzerbefehl, insbesondere in Form eines Klicks, einer Handzeicheneingabe, einer Spracheingabe oder einer Texteingabe. Dementsprechend erfolgt die Platzierungsmaßnahme durch den Benutzer in Form eines Befehls. Hierzu sind unterschiedliche Eingabemöglichkeiten oder Befehle möglich. Alternativ kann die Recheneinheit die Platzierung selbst durchführen ohne Nutzerinteraktion, insbesondere eine Anweisung ausführen. Vor der Platzierung durch die Recheneinheit kann der Benutzer den bestimmten Bereich oder die Stelle des zu platzierenden Elements durch die Recheneinheit bestätigen.

In einer weiteren Ausgestaltung weist das Verfahren weiterhin das Anpassen des mindestens einen Eingabemodells durch Bestimmen und Ergänzen der Position oder Stelle des platzierten Elementes und/oder Anpassen anderer zugehöriger Daten des platzierten Elementes nach dem Durchführen der mindestens einen Platzierungsmaßnahme auf.

In einer weiteren Ausgestaltung weist das Verfahren weiterhin das Aktualisieren des Eingabemodells anhand der angepassten Daten auf.

Dementsprechend wird das Eingabemodell nach dem Durchführen des erfindungsgemäßen Verfahrens aktualisiert, um die bestimmten Bereiche zu berücksichtigen. Beispielsweise können keine weiteren zu platzierenden Elemente über dem bereits platzierten Element bzw. an dessen Stelle platziert werden. Ferner betrifft die Erfindung eine Recheneinheit zum Durchführen des obigen Verfahrens.

Die Erfindung betrifft ferner ein Computerprogrammprodukt mit einem Computerprogramm, das Mittel zur Durchführung des oben beschriebenen Verfahrens, wenn das Computerprogramm auf einer programmgesteuerten Einrichtung zur Ausführung gebracht wird. Ein Computerprogrammprodukt, wie z.B. ein Computerprogramm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen. Als programmgesteuerte Einrichtung kommt insbesondere eine Steuereinrichtung, wie beispielsweise eine Industriesteuerungs-PC oder eine Speicherprogrammierbare Steuerung oder ein Programmable Logic Controller, kurz PLC, oder ein Mikroprozessor für eine Smartcard oder dergleichen in Frage.

### 5. Kurze Beschreibung der Zeichnungen

In der folgenden detaillierten Beschreibung werden vorliegend bevorzugte Ausführungsformen der Erfindung weiter beschrieben mit Bezug auf die folgenden Figuren.
- FIG 1: zeigt ein erfindungsgemäßes Ablaufdiagramm.
- FIG 2: zeigt ein Eingabemodell mit dem zu platzierenden Element vor der Platzierung gemäß einer Ausführungsform der Erfindung.
- FIG 3: zeigt ein Eingabemodell mit dem platzierten Element nach der Platzierung gemäß einer Ausführungsform der Erfindung.

### 6. Beschreibung der bevorzugten Ausführungsformen

Im Folgenden werden bevorzugte Ausführungsformen der vorliegenden Erfindung in Bezug auf die Figuren beschrieben.

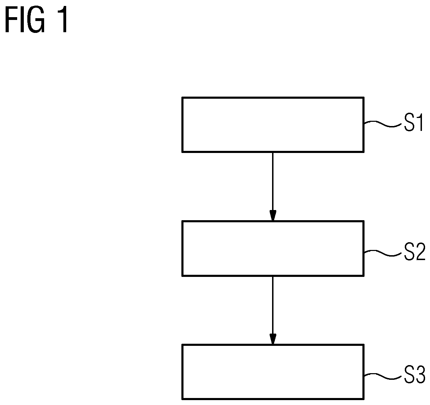

Figur 1 stellt ein Ablaufdiagramm des erfindungsgemäßen Verfahrens mit den Verfahrensschritten S1 bis S3 schematisch dar. Die einzelnen Verfahrensschritte können jeweils durch die Recheneinheit oder auch deren Untereinheiten durchgeführt werden.

In der Recheneinheit kann ein dreidimensionales Modell eines Gebäudes gespeichert werden. Das dreidimensionale digitale Modell kann ein computergeneriertes CAD- oder ifc-Modell sein, in dem die Gebäudeteile semantisch annotiert sind, wie beispielsweise 3D Körper y ist eine Türe. Das dreidimensionale Modell wird als Eingabemodell 10 bezeichnet.

Die Recheneinheit kann ferner mit einer oder mehreren Einheiten verbunden sein, wie Anzeigeeinheit. Die Anzeigeneinheit kann dem Benutzer jegliche Daten dreidimensional darstellen. Der Benutzer kann demnach mit Hilfe einer VR-Brille oder AR-Brille das Gebäude dreidimensional wahrnehmen.

Weiterhin können in der Recheneinheit Regeln und/oder Normen 30 hinterlegt werden, die für die Platzierung zu platzierender Elemente 20 im Gebäude verwendet werden müssen. Dies kann zum Beispiel eine Abstandsregel 30 für Brandmelder 20 sein. Die Abstandsregel kann darauf gerichtet sein, dass Brandmelder von der Wand einen Abstand von mindestens 50 cm haben. Eine weitere Regel kann darauf gerichtet sein, dass die Erfassungsbereiche der Brandmelder im Raum die Grundfläche des Raums abdecken. Die Regeln können sich zwischen verschiedenen Verwaltungsbereichen unterscheiden (regional, Land, Bundesland, Kanton etc.). Ferner können sich die Regeln zwischen verschiedenen Nutzungstypen der Gebäude unterscheiden (Bürogebäude, Krankenhaus, Flughafen, Wohnhaus, Lagerhaus etc.). Innerhalb des Gebäudes können sich die Regeln auch zwischen verschiedenen Raumtypen unterscheiden (Büro, Küche, Waschraum, Lager etc.).

Zusätzlich kann die Recheneinheit oder eine Speichereinheit der Recheneinheit die Daten speichern.

Im Fall einer Darstellung im virtuellen Raum, VR, wird durch die Recheneinheit ein virtuelles Modell des Gebäudes erzeugt, durch das sich der Benutzer virtuell bewegen kann. VR hat sich hinsichtlich Neubauten in der frühen Planungsphase als besonders vorteilhaft erwiesen. Der Benutzer kann in einem Menü oder durch Sprachbefehl das zu platzierende Element 20 auswählen S2, beispielsweise einen Detektor. Daraufhin wird die zugehörige Regel 30 bestimmt oder ausgewählt sowie auf das Eingabemodell 10 angewendet. Beispielsweise ergibt sich aus dem Eingabemodell 10, dass es sich bei dem Gebäude um den Nutzungstyp eines Flughafens handelt. Für den beispielhaften Flughaften gilt ein spezieller Regelsatz 30 zur Geräteplatzierung, welcher bestimmt bzw. ausgewählt wird S2. Daraufhin werden anhand der zugehörigen Regel die gültigen und ungültigen Bereiche 12, 14 für eine Platzierung des zu platzierenden Elements 20 bestimmt S3. Diese Bereiche 12, 14 können dem Benutzer optisch dargestellt werden, beispielsweise die ungültigen Bereiche in rot und/oder die gültigen Bereiche in grün. Alternativ oder zusätzlich zur Farbe können jegliche andere Markierungsarten verwendet werden. Der Benutzer kann das zu platzierende Element 20 platzieren indem er den Ort oder die Stelle für die Platzierung durch seine Blickrichtung bestimmt (Fadenkreuz oder Gerätesymbol) und eine Platzierungsmaßnahme durchführt (z.B. Klicken auf Zeigegerät oder Sprachbefehl). Alternativ oder zusätzlich kann der Ort oder die Stelle für die Platzierung durch ein zusätzliches Zeigegerät bestimmt werden, dessen Lage im Raum mit der VR-System referenziert wird. Daraufhin kann das Gerät in der virtuellen Umgebung angezeigt und seine Position im digitalen Gebäudemodell gespeichert werden.

Die abgeschlossene Platzierung des platzierten Elements 20 kann die gültigen Bereiche 12 für die Platzierung weiterer Elemente ändern. Insbesondere können keine weiteren Elemente direkt über dem vorhandenen platzierten Element 20 platziert werden. Die Platzierung weiterer Elemente im Abdeckungsbereich des bereits platzierten Elements 20 ist insbesondere hinsichtlich ökonomischer Gesichtspunkte von Nachteil. Daher können die zulässigen und unzulässigen Bereiche 12, 14 anhand des aktualisierten Eingabemodells 10 neu berechnet und visualisiert werden.

Falls ein zu platzierendes Element 20 in einem unzulässigen Bereich 14 platziert wird, kann dieser Platzierungsversuch als Fehler erkannt und dem Benutzer angezeigt werden. Eine bewusste Platzierung kann weitere Schritte vorsehen, welche auch dokumentiert werden können. Alternativ oder zusätzlich kann die Recheneinheit selbstständig einen neuen Ort für das zu platzierende Element 20 finden, gegebenenfalls optimiert hinsichtlich Kosten, Sichtbarkeit, Kabellänge etc. Diese Position wird dann virtuell angezeigt und muss lediglich bestätigt werden.

Im Fall der Darstellung in Mixed oder Augmented Reality Umgebungen ist ebenfalls das obige Verfahren anwendbar. AR hat sich hinsichtlich der Renovierung von Bestandsgebäuden oder nach der Rohbauphase von Neubauten als besonders vorteilhaft erwiesen.

Hierbei sind die folgenden Besonderheiten von Bedeutung. Nachdem der Benutzer sich in diesem Fall tatsächlich vor Ort in dem Gebäude befindet in dem das zu platzierende Element platziert werden soll, kann der regionale Gültigkeitsbereich der zugehörigen Regel 30 über eine Positionsbestimmungseinheit ermittelt werden. Ferner kann die Position des Benutzers im Eingabemodell 10 anhand von Indoor-Positioningsystemen festgestellt werden, beispielsweise Marker, WLAN-Tracking etc. Ferner können zusätzliche Hindernisse durch eine Scanner-Einheit berücksichtigt werden, die im Eingabemodell nicht eingetragen sind. Bei den Hindernissen kann es sich beispielsweise um Pflanzen oder Mobiliar etc. handeln. Das Anzeigen der Stelle oder des Orts für die Platzierung des Geräts kann durch ein im echten Gebäude sichtbares, durch die Kameraeinheit einer AR-Brille oder im Smartphone erfassbares Zeigeelement erfolgen. Bei dem Zeigeelement kann es sich beispielsweise um einen Laser-Pointer, Zeigen mit dem Finger oder Zeigestab handeln.

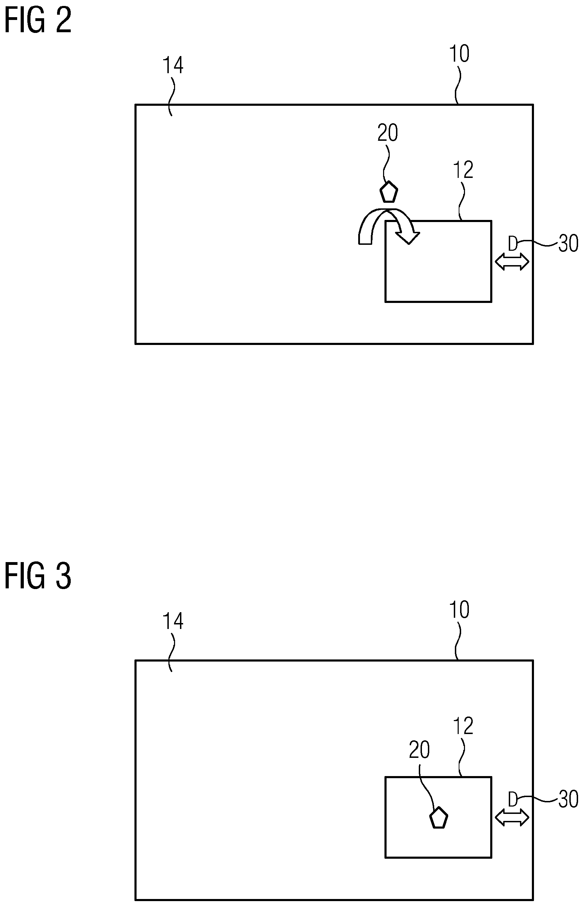

Die Figuren 2 und 3 zeigen jeweils ein Eingabemodell 10 gemäß einer Ausführungsform der Erfindung. Das Eingabemodell 10 weist einen bestimmten gültigen Bereich 12 auf, in welches das zu platzierende Element 20 zulässig platziert werden kann. Der gültige Bereich wird durch das erfindungsgemäße Verfahren bestimmt. In diesem Bereich wird der Mindestabstand D, 30 als zugehörige Bedingung erfüllt.

Figur 2 zeigt das zu platzierende Elemente nach Verfahrensschritt 3, vor der Platzierung. Figur 3 hingegen zeigt das bereits platzierte Element.

## Patentansprüche

1. Computer-implementiertes Verfahren zum Bestimmen mindestens eines Bereichs (12, 14) in mindestens einem Eingabemodell (10) für mindestens ein zu platzierendes Element (20), aufweisend die Schritte:
a. Empfangen eines Eingabedatensatzes aufweisend das mindestens eine zu platzierende Element (20), eine Vielzahl von Bedingungen (30) und das mindestens eine Eingabemodell (10) (S1); wobei das Eingabemodell (10) ein zweidimensionales oder dreidimensionales digitales Modell ist;
b. Bestimmen mindestens einer zugehörigen Bedingung (30) aus der Vielzahl von Bedingungen (S2); und
c. Bestimmen mindestens eines Bereichs des mindestens einen Eingabemodells (10), wobei der mindestens eine Bestimmte Bereich in Abhängigkeit von der zugehörigen Bedingung ein gültiger Bereich (12) oder ein ungültiger Bereich (14) ist; wobei
d. der mindestens eine gültige Bereich (12) die zugehörige Bedingung (30) zumindest zum Teil erfüllt;
e. Anzeigen des mindestens einen gültigen Bereichs (12) und/oder des mindestens einen ungültigen Bereichs (14) durch eine Anzeigeeinheit; wobei die Anzeigeeinheit als eine Virtual Reality, VR, Brille ausgebildet ist;
f. Platzieren des mindestens einen zu platzierenden Elementes (20) in den mindestens einen bestimmten Bereich des Eingabemodells (10); wobei das Platzieren das
- Bestimmen der Position oder Stelle der Platzierung des mindestens einen zu platzierenden Elementes (20) in dem mindestens einen bestimmten Bereich durch die Blickrichtung eines Benutzers und das Durchführen mindestens einer Platzierungsmaßnahme umfasst;
- Ausgeben eines Platzierungsfehlers nach erfolgloser Platzierung im Fehlerfall, falls die bestimmte Position oder Stelle der Platzierung in einem ungültigen Bereich (14) ist;
g. Anpassen des mindestens einen Eingabemodells (10) durch Bestimmen und Ergänzen der Position oder Stelle des platzierten Elementes (20) und/oder Anpassen anderer zugehöriger Daten des platzierten Elementes (20) nach dem Durchführen der mindestens einen Platzierungsmaßnahme; und
h. Aktualisieren des mindestens einen Eingabemodells (10) anhand der angepassten Daten.

2. Computer-implementiertes Verfahren nach Anspruch 1, weiterhin aufweisend Anzeigen des platzierten Elementes (20) in dem mindestens einen gültigen Bereich (12) nach dem Durchführen der mindestens einen Platzierungsmaßnahme und/oder Anzeigen des Platzierungsfehlers nach Erkennung des Platzierungsfehlers.

3. Computer-implementiertes Verfahren nach Anspruch 1 oder Anspruch 2, wobei die mindestens eine Platzierungsmaßnahme ein Nutzerbefehl ist, insbesondere in Form eines Klicks, einer Handzeicheneingabe, einer Spracheingabe oder einer Texteingabe.

4. Recheneinheit angepasst zum Durchführen des Verfahrens nach einem der vorhergehenden Ansprüche.

5. Computerprogrammprodukt mit einem Computerprogramm, das Mittel zur Durchführung des Verfahrens nach einem der Ansprüche 1 bis 3 aufweist, wenn das Computerprogramm auf einer programmgesteuerten Einrichtung zur Ausführung gebracht wird.

## Claims

1. Computer-implemented method for determining at least one region (12, 14) in at least one input model (10) for at least one element (20) to be placed, comprising the following steps:
a. receiving an input data set comprising the at least one element (20) to be placed, a plurality of conditions (30) and the at least one input model (10) (S1); wherein the input model (10) is a two-dimensional or three-dimensional digital model;
b. determining at least one associated condition (30) from the plurality of conditions (S2); and
c. determining at least one region of the at least one input model (10), wherein the at least one determined region, depending on the associated condition, is a valid region (12) or an invalid region (14); wherein
d. the at least one valid region (12) satisfies the associated condition (30) at least in part;
e. displaying the at least one valid region (12) and/or the at least one invalid region (14) by means of a display unit; wherein the display unit is configured as virtual reality, VR, glasses;
f. placing the at least one element (20) to be placed into the at least one determined region of the input model (10); wherein the placing comprises
- determining the position or location of the placement of the at least one element (20) to be placed in the at least one determined region by way of the viewing direction of a user and carrying out at least one placement measure;
- outputting a placement error after unsuccessful placement in the case of an error if the determined position or location of the placement is in an invalid region (14);
g. adapting the at least one input model (10) by determining and adding the position or location of the placed element (20) and/or adapting other associated data of the placed element (20) after carrying out the at least one placement measure; and
h. updating the at least one input model (10) on the basis of the adapted data.

2. Computer-implemented method according to Claim 1, further comprising displaying the placed element (20) in the at least one valid region (12) after carrying out the at least one placement measure and/or displaying the placement error after detecting the placement error.

3. Computer-implemented method according to Claim 1 or Claim 2, wherein the at least one placement measure is a user command, in particular in the form of a click, a hand signal input, a voice input or a text input.

4. Computing unit adapted for carrying out the method according to any of the preceding claims.

5. Computer program product having a computer program which comprises means for carrying out the method according to any of Claims 1 to 3 when the computer program is executed on a program-controlled device.

## Revendications

1. Procédé mis en oeuvre par ordinateur pour déterminer au moins une zone (12, 14) dans au moins un modèle d'entrée (10) pour au moins un élément à placer (20), comprenant les étapes suivantes :
a. la réception d'un ensemble de données d'entrée comprenant l'au moins un élément à placer (20), une pluralité de conditions (30) et l'au moins un modèle d'entrée (10) (S1) ; dans lequel le modèle d'entrée (10) est un modèle numérique bidimensionnel ou tridimensionnel ;
b. la détermination d'au moins une condition associée (30) parmi la pluralité de conditions (S2) ; et
c. la détermination d'au moins une zone de l'au moins un modèle d'entrée (10), dans lequel l'au moins une zone déterminée est une zone valide (12) ou une zone invalide (14) en fonction de la condition associée ;
d. dans lequel l'au moins une zone valide (12) remplit au moins partiellement la condition associée (30) ;
e. l'affichage de l'au moins une zone valide (12) et/ou de l'au moins une zone invalide (14) par une unité d'affichage ; dans lequel l'unité d'affichage est conçue comme des lunettes en réalité virtuelle, RV ;
f. le placement de l'au moins un élément à placer (20) dans l'au moins une zone spécifique du modèle d'entrée (10) ; dans lequel le placement
- comprend la détermination de la position ou du lieu de placement de l'au moins un élément à placer (20) dans l'au moins une zone spécifique dans la direction de visualisation d'un utilisateur et la réalisation d'au moins une mesure de placement ;
- l'émission d'une erreur de placement après un placement infructueux en cas d'erreur si la position ou l'emplacement spécifique du placement se trouve dans une zone invalide (14) ;
g. l'ajustement de l'au moins un modèle d'entrée (10) en déterminant et en ajoutant la position ou l'emplacement de l'élément placé (20) et/ou en ajustant d'autres données associées de l'élément placé (20) après réalisation de l'au moins une mesure de placement ; et
h. la mise à jour de l'au moins un modèle d'entrée (10) sur la base des données ajustées.

2. Procédé mis en oeuvre par ordinateur selon la revendication 1, comprenant en outre l'affichage de l'élément placé (20) dans l'au moins une zone valide (12) après réalisation de l'au moins une mesure de placement et/ou l'affichage de l'erreur de placement après détection de l'erreur de placement.

3. Procédé mis en oeuvre par ordinateur selon la revendication 1 ou la revendication 2, dans lequel l'au moins une mesure de placement est une commande utilisateur, en particulier sous la forme d'un clic, d'une saisie de signal manuel, d'une saisie vocale ou d'une saisie de texte.

4. Unité de calcul adaptée pour mettre en oeuvre le procédé selon l'une des revendications précédentes.

5. Produit de programme informatique comportant un programme informatique présentant des moyens pour mettre en oeuvre le procédé selon l'une des revendications 1 à 3 lorsque le programme informatique est exécuté sur un dispositif commandé par programme.
